# EUROPEAN PATENT SPECIFICATION

(11) **EP 2 918 362 B1**
(45) Date of publication and mention of the grant of the patent: **07.07.2021**
(21) Application number: 12887999.6
(22) Date of filing: 07.11.2012
(51) Int. Cl.: B23G 7/02, C23C 14/06, C23C 30/00

(54) **HARD FILM-COATED CUTTING TOOL**
MIT EINEM HARTFILM BESCHICHTETES SCHNEIDEWERKZEUG
OUTIL DE COUPE À REVÊTEMENT DE FILM DUR

(43) Date of publication of application: 16.09.2015
(73) Proprietor: OSG Corporation, Aichi 442-0005 (JP)
(72) Inventor: TOIHARA Takaomi, Toyokawa-shi Aichi 442-0005 (JP)
(74) Representative: TBK
(86) International application number: PCT/JP2012/078897
(87) International publication number: WO 2014/073062

(56) References cited:
- EP-A1- 0 933 157
- JP-A- 2001 316 800
- JP-A- 2007 084 899
- JP-A- 2007 084 899
- JP-A- 2009 297 864
- US-A1- 2003 059 632
- NOETZEL V ET AL: "SICHERES GEWINDEN IN DER AUTOMOBILINDUSTRIE", WERKSTATT + BETRIEB, CARL HANSER VERLAG, MÜNCHEN DE, vol. 138, no. 12, 1 December 2005 (2005-12-01), pages 43-45, XP001237086, ISSN: 0043-2792

## Description

### TECHNICAL FIELD

The present invention relates to a thread forming tap having a hard film disposed as coating on a surface by a sputtering method and particularly to an improvement for reducing a cutting resistance.

### BACKGROUND ART

Cutting tools such as drills and taps are provided and coated with a hard film to improve abrasion resistance. TiN-based, TiCN-based, TiAlN-based, and AlCrN-based coatings are widely used for this cutting tool hard film, which is disposed as coating on surfaces of tools by a sputtering method (a sputter vapor deposition method), for example. For example, an amorphous carbon coating member described in Patent Document 1 is an example thereof.

Patent Document 2 describes a TiN coated thread forming tap having the features set forth in the preamble of claim 1.

### PRIOR ART DOCUMENTS

### Patent Documents

Patent Document 1: JP 2001 316800 A, &US 6 821 624 B2
Patent Document 2: Volker Nötzel et al.: "Sicheres Gewinden in der Automobilindustrie", Werkstatt + Betrieb, Carl Hanser Verlag, München, vol. 138, no. 12, pp. 43-45

### SUMMARY OF THE INVENTION

### Problem to Be Solved by the Invention

Cutting tools including thread forming taps are required to reduce a cutting resistance (cutting torque) during cutting. Although the cutting resistance has been reduced by improving tool shapes and coating film components in conventional techniques as described above, a sufficient effect cannot be acquired and room for improvement exists. Therefore, it is requested to develop a thread forming tap reducing the cutting resistance.

The present invention was conceived in view of the situations and it is therefore an object of the present invention to provide a thread forming tap reducing a cutting resistance.

### Means for Solving the Problem

To achieve the object, the first aspect of the invention provides a thread forming tap comprising the features defined in claim 1.

### Effects of the Invention

According to the first aspect of the invention, since a thread forming tap comprises a hard film disposed as coating on a surface of a tool parent material by a sputtering method, the thread forming tap includes a plurality of dome-shaped protrusions in a practical form formed on the surface of the hard film disposed as coating on an advancing-side flank surface, the surface provided with the plurality of the protrusions comes into point contact with a work material while a cutting oil is easily retained between the protrusions, which can significantly reduce the cutting resistance. Therefore, the thread forming tap reducing the cutting resistance can be provided.

The second aspect of the invention provides the thread forming tap recited in the first aspect of the invention, wherein the protrusions are formed on a surface of a portion tilted by an angle within a range from 90° to 180° relative to a tool advancing direction of an axial center direction of the thread forming tap. Consequently, a plurality of protrusions are formed on the surface on the tool advancing side particularly having a problem of contact resistance with a work material and, therefore, the surface comes into point contact with the work material while a cutting oil is easily retained between the protrusions, which can significantly reduce the cutting resistance.

The third aspect of the invention provides the thread forming tap recited in the first or second aspect of the invention, wherein a total film thickness of the hard film is within a range from 0.5 µm to 3.0 µm. Consequently, since a plurality of protrusions are formed on the surface with the hard film in a practical form disposed as coating, the surface comes into point contact with the work material and the cutting resistance can significantly be reduced.

The above-mentioned and further aspects of the present invention will become more apparent from the following description.

### BRIEF DESCRIPTION OF THE DRAWINGS

Fig. 1 is a front view for explaining a configuration of a thread forming tap that is a preferred embodiment of the present invention.
Fig. 2 is a cross-sectional view taken along II-II depicted in Fig. 1.
Fig. 3 is an enlarged partial front view of a portion of a tap portion for explaining a configuration of a screw thread in the thread forming tap of Fig. 1 in detail.
Fig. 4 is a schematic cross-sectional view of a cross section taken along IV-IV of Fig. 3.
Fig. 5 depicts a scanning electron microscope photograph of surface characteristics of the hard film disposed as coating on a following-side flank surface of the tap portion of the thread forming tap in Fig. 1.
Fig. 6 depicts a scanning electron microscope photograph of surface characteristics of the hard film disposed as coating on the advancing-side flank surface of the tap portion of the thread forming tap in Fig. 1.
Fig. 7 is a diagram for explaining an example of a coating method of the hard film for the thread forming tap of Fig. 1.
Fig. 8 is a process diagram for explaining a main portion of an example of a method of forming the hard film for the thread forming tap of Fig. 1.
Fig. 9 is a diagram for indicating a structure of samples in a tapping torque comparison test conducted by the present inventors for verifying the effect of the present invention along with a test result thereof.
Fig. 10 is a diagram for exemplifying heating conditions, bombardment conditions, and coating conditions of the samples in Fig. 9.

### MODE FOR CARRYING OUT THE INVENTION

Although cemented carbide and high speed tool steel are preferably used as a tool parent material, i.e., a material of a member provided with the hard film, other materials are also available and, for example, the present invention is widely applied to various materials such as cermet, ceramics, polycrystalline diamond, single-crystal diamond, polycrystalline CBN, and single-crystal CBN.

The hard film coating the thread forming tap is preferably one of well-known TiN-based, TiCN-based, TiAlN-based, and AlCrN-based hard films and is disposed as coating on a portion or the whole of the surface of the thread forming tap. Preferably, the hard film is disposed on a cutting portion involved with cutting in the thread forming tap. More preferably, the hard film is disposed to coat at least a cutting edge or a rake surface in the cutting portion.

A preferred embodiment of the present invention will now be described in detail with reference to the drawings. For convenience of description, portions are not necessarily precisely depicted in the drawings used in the following description in terms of dimension ratio, etc.

### Embodiment

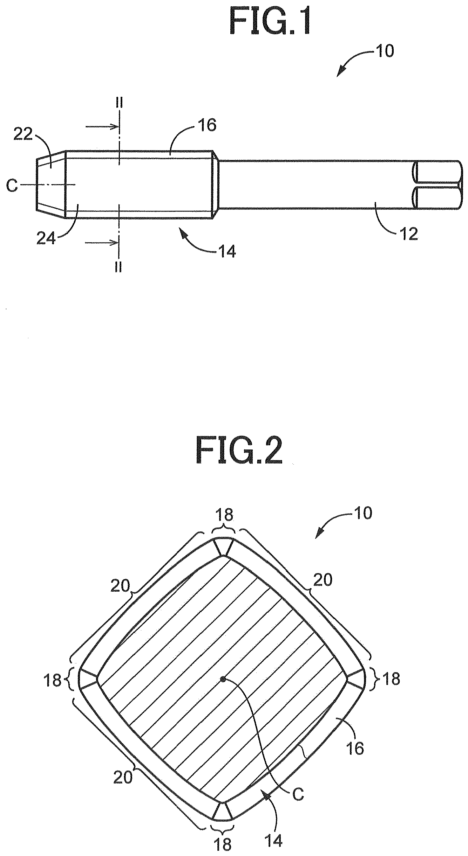

Fig. 1 is a front view for explaining a configuration of a thread forming tap (rolled tap) 10 that is a preferred embodiment of the present invention. As depicted in Fig. 1, the thread forming tap 10 of this embodiment includes a circular column-shaped (cylindrically-shaped) shank portion 12, and a tap portion 14 integrally formed on the tip side of the shank portion 12 concentrically (on a common axial center C) to the shank portion 12. A screw thread (male thread) 16 is formed on the outer circumferential side of the tap portion 14 and corresponds to a female thread to be machined (female thread to be machined by the thread forming tap 10). The tap portion 14 is preferably formed integrally with the shank portion 12; however, the tap portion 14 may detachably be configured for the shank portion 12. In such a form, the tap portion 14 is integrally fixed to a tip portion of the shank portion 12 when used in machining of the female thread by the thread forming tap 10.

Fig. 2 is a cross-sectional view when a portion of the thread forming tap 10 is cut by a plane including the axial center C (a cross-sectional view taken along II-II depicted in Fig. 1). The screw thread 16 is formed into a male thread shape along a helix corresponding to a prescribed lead angle with margin portions 18 disposed to project in a radial direction and relief portions 20 having a diameter smaller than the margin portions 18 alternatively arranged. These margin portions 18 correspond to portions cutting into a prepared hole (a surface layer portion) of a work in the machining of the female thread by the thread forming tap 10. In other words, the margin portions 18 correspond to acting parts for plastically deforming a prepared hole of a work in the machining of the female thread by the thread forming tap 10 and are projecting portions (lands) disposed to project in a radial direction in accordance with a shape of the female thread to be machined. For example, as depicted in Fig. 2, the screw thread 16 forms a substantially rectangle-shaped cross section (viewed cross-section) when viewed in the axial center C direction, and the positions corresponding to the four vertexes of the rectangle shape are formed to project in a radial direction as the margin portions 18 while the relief portions 20 having a diameter smaller than the margin portions 18 are disposed between the margin portions 18.

As depicted in Fig. 1, the tap portion 14 includes a biting portion 22 formed into a tapered shape with a radial dimension gradually reduced toward the tip side (with a diameter made smaller toward the tip side), and a complete thread portion 24 formed into a circular column shape (cylindrical shape) with a substantially constant radial dimension. The biting portion 22 is a portion for cutting into a surface layer portion of a prepared hole in a work and plastically deforming the surface layer portion to form a female thread by form-rolling in the machining of the female thread by the thread forming tap 10, and corresponds to a configuration of several crests (e.g., two to five crests) from the tip side of the screw thread 16. The complete thread portion 24 is a portion for finishing female thread surfaces formed by the biting portion 22 and improving guidance or a self-guiding property of the tap portion 14 in the machining of the female thread by the thread forming tap 10. The complete thread portion 24 is formed into a shape substantially identical to the shape of a screw thread of the female thread to be machined by the thread forming tap 10. Although not particularly described in this embodiment, the tap portion 14 may have one or more oil groves formed in the axial center C direction.

The thread forming tap 10 configured as described above causes the margin portions 18 of the screw thread 16 to cut into a surface layer portion of a prepared hole of a work for forming (thread forming) and machining of a female thread through plastic deformation of the surface layer portion. For example, the thread forming tap 10 is attached at the shank portion 12 to a tapping machine and lead feed is performed in an axial direction while the shank portion 12 is rotationally driven, for example, clockwise when viewed from the shank portion 12, relative to the prepared hole that is an object of formation of a female thread, thereby screwing the tap portion 14 disposed on the tip side of the shank portion 12 into the prepared hole. As a result, the biting portion 22 cuts into a surface layer portion (an inner circumferential surface) of the prepared hole and plastically deforms the surface layer portion to form the female thread by form-rolling, and the complete thread portion 24 finishes the shaped female thread surfaces, so as to form the intended female thread in the prepared hole. Such machining by the thread forming tap 10 is preferably applied to formation of a female thread in material excellent in ductility and can advantageously form a highly accurate female thread without generating chips although a relatively large torque is applied to the thread forming tap 10 during formation of the female thread.

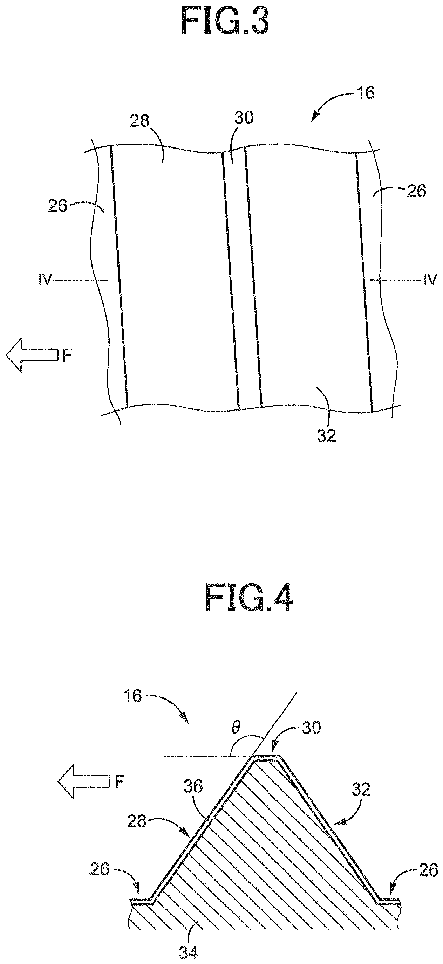

Fig. 3 is an enlarged partial front view of a portion of the tap portion 14 for explaining a configuration of the screw thread 16 in detail. Fig. 4 is a schematic cross-sectional view of a cross section taken along IV-IV of Fig. 3. Figs. 3 and 4 include a white arrow F indicative of a tool advancing side (tip side) in the axial center C direction of the thread forming tap 10 and exemplarily illustrate a root 26, an advancing-side flank surface 28, a crest 30, a following-side flank surface 32, and a root 26 corresponding to one crest of the screw thread 16. The advancing-side flank surface 28 is a flank surface facing in the advancing direction when the tap portion 14 is screwed into a prepared hole formed in a work, and the following-side flank surface 32 is a flank surface disposed on the side opposite to the advancing-side flank surface 28 in terms of the axial center C direction of the thread forming tap 10. As depicted in Fig. 4, based on the tool advancing side (tip side) in the axial center C direction of the thread forming tap 10, a tilt angle θ of the advancing-side flank surface 28 relative to the axial center C is within a range of 90° or more to 180° or less and is preferably about 120°. A tilt angle of the following-side flank surface 32 relative to the axial center C is, for example, 180°-θ, and within a range of 0° or more to 90° or less and is preferably about 60°.

As depicted in Fig. 4, the tap portion 14 of the thread forming tap 10 of the this embodiment has, for example, a TiN-based, TiCN-based, TiAlN-based, or AlCrN-based hard film 36 disposed as coating on a surface of a tool parent material (tool base material) 34. The hard film 36 is disposed as coating on the surface of the tool parent material 34 by a well-known sputtering method (sputter vapor deposition method) described later and is preferably disposed to coat the entire surface of the tap portion 14, or is disposed to coat at least the margin portions 18 of the tap portion 14. Therefore, the hard film 36 is disposed to coat at least the portion involved with cutting in the thread forming tap 10 as a hard film coated cutting tool. A total film thickness of the hard film 36 is preferably within a range of 0.5 µm or more to 3.0 µm or less.

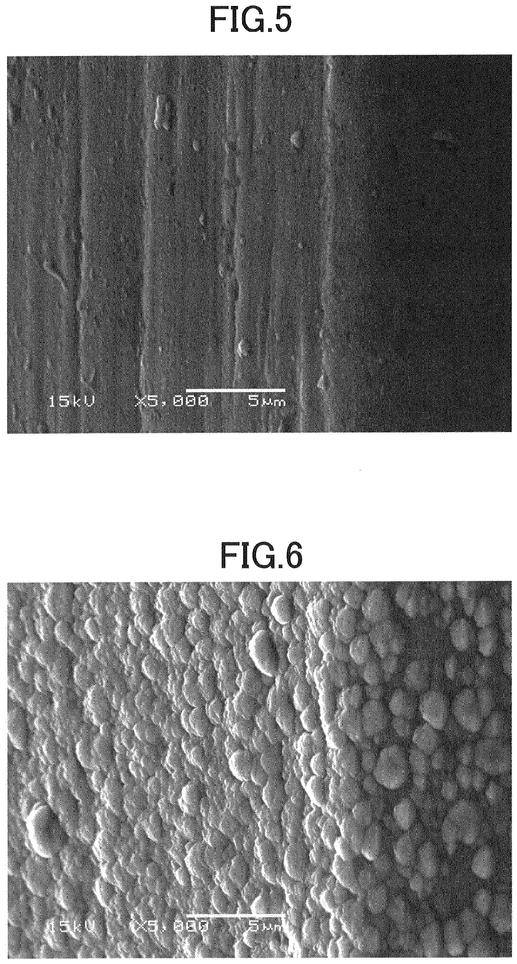

Fig. 5 depicts a scanning electron microscope photograph of surface characteristics of the hard film 36 disposed as coating on the root 26, the crest 30, and the following-side flank surface 32 of the tap portion 14 of the thread forming tap 10, and Fig. 6 depicts a scanning electron microscope photograph of surface characteristics of the hard film 36 disposed as coating on the advancing-side flank surface 28 of the tap portion 14. As depicted in Fig. 6, the thread forming tap 10 of this embodiment has a multiplicity of dome-shaped protrusions formed on the surface of the hard film 36 disposed as coating on the advancing-side flank surface 28. The dome shape corresponds to an approximately hemispherical shape, a hill shape, or a cupola shape, may have any approximately circular shape in a planar view, and may have a flattened shape in a side view. The protrusions are preferably constructed by disposing the hard film 36 as coating on a surface of the tool parent material 34 after the surface is roughened as a result of a bombardment treatment applied to the surface of the tool parent material 34 before a coating treatment of the hard film 36 to the tool parent material 34 as described later. On the other hand, as depicted in Fig. 5, none of the protrusions is formed on the surface of the hard film 36 disposed as coating on the root 26, the crest 30, and the following-side flank surface 32 of the thread forming tap 10 of this embodiment so that flat surface characteristics are achieved as is the case with conventional hard films. In other words, the thread forming tap 10 has a multiplicity of the protrusions formed on the surface of the hard film 36 disposed as coating on the portion tilted by an angle within a range from 90° to 180° relative to the tool advancing direction (tip direction) of the axial center C direction , while none of the protrusions is formed on the surface of the hard film 36 disposed as coating on the portions out of the angle range.

The protrusions formed on the surface with the hard film 36 disposed as coating preferably have a maximum radius thereof within a range of 0.1 µm or more to 2.0 µm or less. The maximum radius of the protrusions is an approximate radius of a base of a protrusion in a planar view of the individual protrusions. Preferably, a maximum value of the radiuses of the plurality of the protrusions is within a range of 0.1 µm or more to 2.0 µm or less. This maximum value is, for example, a value obtained as an approximate radius of a plurality of the protrusions randomly extracted from a surface photograph of the hard film 36 taken by a scanning electron microscope etc. Alternatively, for example, a plurality of ranges of a predetermined area such as 10 µm×10 µm may be extracted from a surface photograph of the hard film 36, and the maximum value may be obtained as a maximum value of approximate radiuses of a plurality of the protrusions included in these ranges.

The protrusions formed on the surface with the hard film 36 disposed as coating preferably have a center distance of protrusions adjacent to each other within a range of 0.2 µm or more to 3.0 µm or less. The center distance of protrusions is a distance between peaks of protrusions (approximate centers of circles corresponding to the bases of protrusions) in a planar view of the individual protrusions. Preferably, an average value of the center distances of the protrusions adjacent to each other is within a range of 0.2 µm or more to 3.0 µm or less. This average value is, for example, a value obtained as an arithmetic mean of the center distances of a plurality of sets of the protrusions adjacent to each other randomly extracted from a surface photograph of the hard film 36 taken by a scanning electron microscope etc. Alternatively, for example, a plurality of ranges of a predetermined area such as 10 µm×10 µm may be extracted from a surface photograph of the hard film 36, and the average value may be obtained as an arithmetic mean of the center distances of the protrusions adjacent to each other included in these ranges.

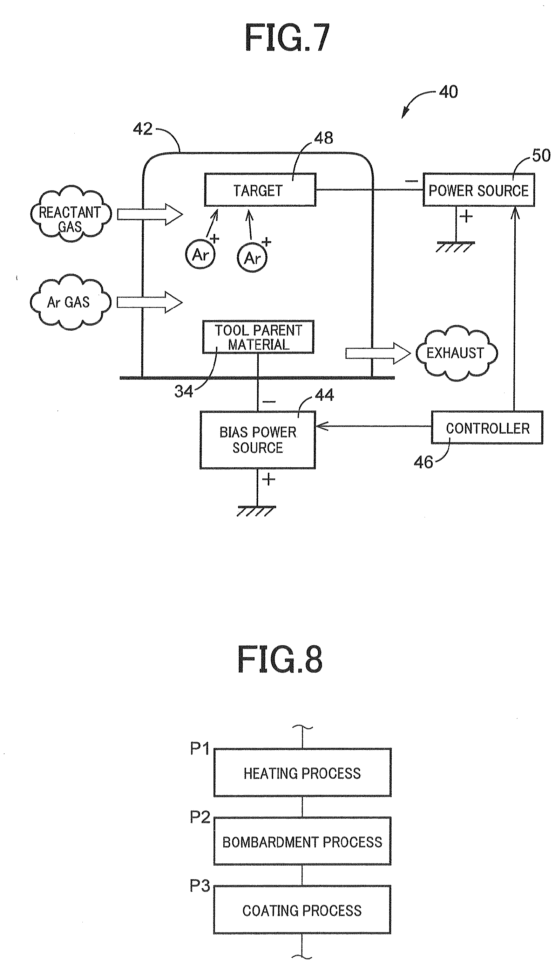

Fig. 7 is a diagram for explaining an example of a coating method of the hard film 36 for the thread forming tap 10 (the tap portion 14) and Fig. 8 is a process diagram for explaining a main portion of an example of a method of forming the hard film 36 for the thread forming tap 10. The coating of the hard film 36 for the thread forming tap 10 etc. is performed under the control of a controller 46 by using a sputtering apparatus 40 as depicted in Fig. 7, for example. Preferably, first, in a heating process P1, a heating treatment is applied to the tool parent material 34. For example, the heating treatment is applied for 90 minutes at heater output of 10000 W.

In a bombardment process (an etching process) P2, a negative bias voltage is applied by a bias power source 44 to the tool parent material 34 placed in a chamber 42 of the sputtering apparatus 40. As a result, a bombardment treatment (an etching treatment) is applied, causing positive argon ions Ar⁺ to collide with the tool parent material 34 and roughening the surface of the tool parent material 34. By controlling the bias voltage and a treating time in the bombardment process P2, characteristics are changed on the surface to be coated with the hard film 36 on the tool parent material 34 and, therefore, characteristics are changed on the surface with the hard film 36 disposed as coating. For example, by applying the bombardment treatment at the bias voltage of -350 to -250 V for the treating time of 10 to 40 minutes, the surface after coating with the hard film 36 has a plurality of protrusions formed as depicted in Fig. 6. By applying the bombardment treatment at the bias voltage of about -200 V for the treating time of about 5 minutes, the surface after coating with the hard film 36 has conventional characteristics without the protrusions as depicted in Fig. 5. Alternatively, even if the bombardment treatment is applied at the same bias voltage and treating time, a degree of surface roughness differs on each of the portions of the tool parent material 34 depending on a direction etc. of the tool parent material 34 placed in the chamber 42. In this embodiment, preferably, the tool parent material 34 is placed in the chamber 42 in a predetermined direction and the controller 46 controls the bias voltage and the treating time in the bombardment treatment such that the advancing-side flank surface 28 of the tap portion 14 has surface characteristics with a plurality of protrusions formed as depicted in Fig. 6 while the remaining portions, i.e., the root 26, the crest 30, and the following-side flank surface 32, have surface characteristics without formation of the protrusions as depicted in Fig. 5. Alternatively, the bombardment treatments may be applied at respective different bias voltages and treating times such that the advancing-side flank surface 28 of the tap portion 14 has surface characteristics with a plurality of protrusions formed as depicted in Fig. 6 while the remaining portions, i.e., the root 26, the crest 30, and the following-side flank surface 32, have surface characteristics without formation of the protrusions as depicted in Fig. 5.

In a coating process (a sputtering process) P3, a constant negative bias voltage (e.g., about -50 to -60 V) is applied by a power source 50 to a target 48, for example, Ti, TiAl, or AlCr making up the hard film 36 while a constant negative bias voltage (e.g., about -50 V) is applied by the bias power source 44 to the tool parent material 34 so as to cause the argon ions Ar⁺ to collide with the target 48, thereby beating out the constituent substance of the hard film 36. A reactant gas such as a nitrogen gas (N₂) and a hydrocarbon gas (CH₄, C₂H₂) is introduced into the chamber 42 at a predetermined flow rate in addition to an argon gas, and nitrogen atoms N and carbon atoms C are combined with Ti, AlCr, etc. beaten out from the target 48 and are attached as the TiN-based, TiCN-based, TiAlN-based, or AlCrN-based hard film 36 to the surface of the tool parent material 34. In the coating process P3, a positive voltage may be applied to the tool parent material 34. In this way, the hard film 36 is formed on the surface of the tool parent material 34 subjected to the bombardment treatment.

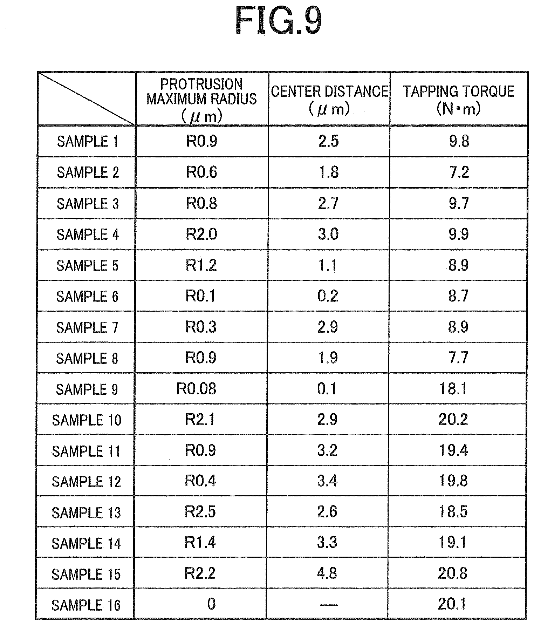

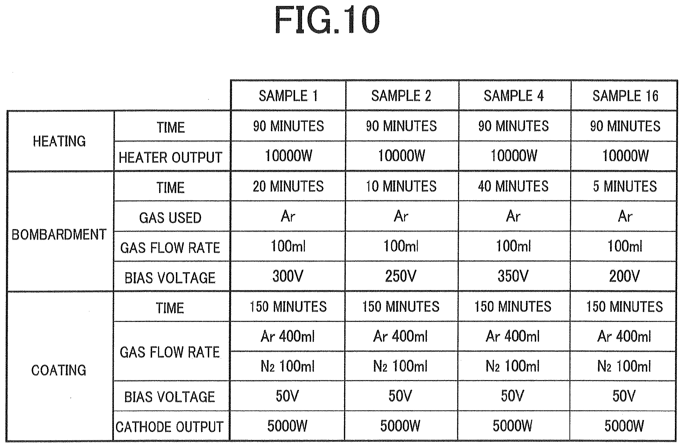

A tapping torque comparison test conducted by the present inventors for verifying the effect of the present invention will then be described. To verify the effect of the present invention, as depicted in Fig. 9, the present inventors created a plurality of types of samples 1 to 16 (thread forming taps) having respective different sizes (maximum radiuses: µm) of a multiplicity of protrusions formed on surfaces with hard films disposed as coating and center distances (µm) of protrusions adjacent to each other, and conducted the tapping torque comparison test to compare the tapping torque (cutting torque) under the following test conditions. The hard films of the samples depicted in Fig. 9 are made of TiAIN and have a total film thickness of 1.5 to 2.5 µm. The protrusions of the samples 1 to 15 are formed on the advancing-side flank surfaces of the thread forming taps. The samples 1 to 8 are the thread forming taps 10 of this embodiment having the maximum radius of the protrusions within a range of 0.1 µm or more to 2.0 µm or less and the center distance of the protrusions adjacent to each other within a range of 0.2 µm or more to 3.0 µm or less. The samples 9 to 15 are thread forming taps of comparison examples in which at least one of the radius of the protrusions and the center distance of the protrusions adjacent to each other does not satisfy the numerical value range. The sample 16 is a conventional thread forming tap without a protrusion formed on a surface with a hard film disposed as coating. Heating conditions, bombardment conditions, and coating conditions related to the hard film formation of the samples 1, 2, 4, and 16 are depicted in Fig. 10 as examples of the coating conditions of the samples.

### [Test Conditions]

Tool used: high-speed steel rolled tap M8×1.25
Work material: SCM440 (JIS G 4105)
30HRC (JIS Z 2245)
Prepared hole shape: ϕ7.4×20 mm (through)
Tapping length: 16 mm (blind)
Cutting speed: 15 m/min (597 min⁻¹)
Cutting oil: water-soluble cutting oil
Machine used: vertical machining center

Fig. 9 depicts tapping torque as a test result of the tapping torque comparison test when cutting (tapping) is performed by each of the samples 1 to 16 under the test conditions. As depicted in Fig. 9, with regard to the samples 1 to 8 that are the thread forming taps 10 of this embodiment having the maximum radius of the protrusions within a range of 0.1 µm or more to 2.0 µm or less and the center distance of the protrusions adjacent to each other within a range of 0.2 µm or more to 3.0 µm or less, it is understood that since the tapping torque is less than 10 N·m, the cutting resistance is sufficiently reduced. With regard to the samples 9 to 15 that are thread forming taps of comparison examples in which at least one of the maximum radius of the protrusions and the center distance of the protrusions adjacent to each other does not satisfy the numerical value range and the sample 16 that is a conventional thread forming tap without a protrusion formed on a surface with a hard film disposed as coating, it is understood that since the tapping torque is about 18 to 21 N·m, the cutting resistance is larger as compared to the samples 1 to 8. From the test result, it is understood that the thread forming tap 10 suppresses the cutting resistance sufficiently smaller as compared to the conventional thread forming tap.

As described above, since this embodiment is the thread forming tap 10 acting as a hard film coated cutting tool having the hard film 36 disposed as coating on a surface of the tool parent material 34 by a sputtering method and having a plurality of dome-shaped protrusions formed on the surface with the hard film 36 disposed as coating, the surface provided with the plurality of the protrusions comes into point contact with a work material while a cutting oil is easily retained between the protrusions, which can significantly reduce the cutting resistance. Therefore, the thread forming tap 10 reducing the cutting resistance can be provided.

Since the protrusions are formed on the surface of the advancing-side flank surface 28 that is a portion tilted by the angle θ within a range from 90° to 180° relative to the tool advancing direction of the axial center C direction of the thread forming tap 10, a plurality of protrusions are formed on the surface on the tool advancing side particularly having a problem of contact resistance with a work material and, therefore, the surface comes into point contact with the work material while a cutting oil is easily retained between the protrusions, which can significantly reduce the cutting resistance.

Since the protrusions have the maximum radius within a range of 0.1 µm or more to 2.0 µm or less, the cutting resistance can significantly be reduced by a plurality of the protrusions in a practical form formed on the surface with the hard film 36 disposed as coating.

Since the center distance of the protrusions adjacent to each other is within a range of 0.2 µm or more to 3.0 µm or less, the cutting resistance can significantly be reduced by a plurality of the protrusions in a practical form formed on the surface with the hard film 36 disposed as coating.

Since the total film thickness of the hard film 36 is within a range of 0.5 µm or more to 3.0 µm or less and a plurality of protrusions are formed on the surface with the hard film 36 in a practical form disposed as coating, the surface comes into point contact with the work material and the cutting resistance can significantly be reduced.

### NOMENCLATURE OF ELEMENTS

10: thread forming tap (hard film coated cutting tool) 12: shank portion 14: tap portion 16: screw thread 18: margin portions 20: relief portions 22: biting portion 24: complete thread portion 26: root 28: advancing-side flank surface 30: crest 32: following-side flank surface 34: tool parent material 36: hard film 40: sputtering apparatus 42: chamber 44: bias power source 46: controller 48: target 50: power source C: axial center

## Claims

1. A thread forming tap (10) comprising a hard film (36) disposed as coating on a surface of a tool parent material (34) by a sputtering method,
**characterized in that**
the thread forming tap (10) includes a plurality of dome-shaped protrusions formed on the surface of the hard film (36) disposed as coating on an advancing-side flank surface (28), wherein
the protrusions have a maximum radius thereof within a range from 0.1 µm to 2.0 µm,
a center distance of the protrusions adjacent to each other is within a range from 0.2 µm to 3.0 µm,and
the protrusions are not formed on a root (26), a crest (30), and a following-side flank surface (32).

2. The thread forming tap (10) of claim 1, wherein the protrusions are formed on a surface of a portion tilted by an angle (θ) within a range from 90° to 180° relative to a tool advancing direction of an axial center (C) direction of the thread forming tap (10).

3. The thread forming tap (10) of claim 1 or 2, wherein a total film thickness of the hard film (36) is within a range from 0.5 µm to 3.0 µm.

## Patentansprüche

1. Gewindeformer (10) mit einer Hartschicht (36), die durch ein Sputterverfahren auf einer Oberfläche eines Werkzeuggrundwerkstoffs (34) als Beschichtung angeordnet ist,
**dadurch gekennzeichnet, dass**
der Gewindeformer (10) eine Vielzahl von kuppelförmigen Vorsprüngen aufweist, die auf der Oberfläche der Hartschicht (36) ausgebildet sind, die auf einer vorlaufseitigen Flankenfläche (28) als Beschichtung angeordnet ist, wobei
die Vorsprünge einen maximalen Radius von ihnen in einem Bereich von 0,1 µm bis 2,0 µm haben,
ein Mittenabstand der nebeneinanderliegenden Vorsprünge in einem Bereich von 0,2 µm bis 3,0 µm liegt und
die Vorsprünge nicht auf einem Gewindegrund (26), einem Gewindescheitel (30) und einer nachlaufseitigen Flankenfläche (32) ausgebildet sind.

2. Gewindeformer (10) von Anspruch 1, wobei die Vorsprünge auf einer Oberfläche eines Abschnitts ausgebildet sind, der bezüglich einer Werkzeugvorschubrichtung einer Achsenmittenrichtung (C) des Gewindebohrers (10) um einen Winkel (θ) in einem Bereich von 90° bis 180° gekippt ist.

3. Gewindeformer (10) von Anspruch 1 oder 2, wobei eine Gesamtschichtdicke der Hartschicht (36) in einem Bereich von 0,5 µm bis 3,0 µm liegt.

## Revendications

1. Taraud de filetage (10) comprenant un film dur (36) disposé sous la forme d'un revêtement sur une surface d'un matériau de base d'outil (34) par un procédé de pulvérisation cathodique,
**caractérisé en ce que** le taraud de filetage (10) contient une pluralité de saillies en forme de dôme formées sur la surface du film dur (36) disposé sous la forme d'un revêtement sur une surface de dépouille latérale d'avancement (28),
dans lequel
les saillies ont un rayon maximal de celles-ci situé dans la plage allant de 0,1 µm à 2,0 µm,
la distance entre centres des saillies mutuellement adjacentes est située dans la plage allant de 0,2 µm à 3,0 µm, et
les saillies ne sont pas formées sur une racine (26), une crête (30), et une surface de dépouille latérale suivante (32) .

2. Taraud de filetage (10) selon la revendication 1, dans lequel les saillies sont formées sur une surface d'une partie inclinée selon un angle (θ) situé dans la plage allant de 90° à 180° par rapport à la direction d'avancement de l'outil en termes de la direction centrale axiale (C) du taraud de filetage (10).

3. Taraud de filetage (10) selon la revendication 1 ou 2, dans lequel l'épaisseur totale du film dur (36) est située dans la plage allant de 0,5 µm à 3,0 µm.
